# EUROPEAN PATENT SPECIFICATION

(11) **EP 0 631 333 B1**
(45) Date of publication and mention of the grant of the patent: **02.06.1999**
(21) Application number: 94301503.2
(22) Date of filing: 02.03.1994
(51) Int. Cl.: H01L 39/24

(54) **Process of fabrication of multilayer high temperature superconductor tapes**
Verfahren zur Herstellung mehrschichtiger Hochtemperatursupraleitender Bänder
Procédé de fabrication bandes multicouches de supraconducteur à haute température

(30) Priority: 22.06.1993 US 80330
(43) Date of publication of application: 28.12.1994
(73) Proprietor: GENERAL ATOMICS, San Diego, California 92121 (US)
(72) Inventor: Woolf, Lawrence Donald, Carlsbad, California 92009 (US); Raggio, William Allan, Del Mar, California 92014 (US); Olstad, Robert Allan, San Diego, California 92127 (US); Ohkawa, Tihiro, La Jolla, California 92037 (US)
(74) Representative: Coxon, Philip

(56) References cited:
- EP-A- 0 476 878
- PATENT ABSTRACTS OF JAPAN vol. 017, no. 047 (E-1313) 28 January 1993 & JP-A-04 262 308 (MITSUBISHI ELECTRIC CORP) 17 September 1992
- PATENT ABSTRACTS OF JAPAN vol. 016, no. 048 (E-1163) 6 February 1992 & JP-A-03 252 007 (CHIYOUDENDOU HATSUDEN KANREN KIKI ZAIRYO GIJUTSU KENKYU KUMIAI) 11 November 1991

## Description

### FIELD OF THE INVENTION

The present invention pertains to a method of manufacturing a high critical temperature superconductor wire. More particularly, the present invention pertains to methods for manufacturing high critical temperature superconductor devices which transmit electrical current over relatively long distances. The present invention is particularly, but not exclusively, useful as a continuous manufacturing process for the fabrication of relatively long high temperature superconductor wires which can be incorporated into transmission cables or into the windings of superconducting magnets.

### BACKGROUND OF THE INVENTION

Recently discovered high temperature superconductors have, for some time now, been seriously considered by many for their potential applications in a variety of technologies. Heretofore, however, for many applications the transmission of electrical current over superconductor circuits has been limited by the inability to manufacture long lengths of high temperature superconducting wire. The challenge here has been at least twofold. First, there is the problem of properly orienting the superconductor grains along the entirety of the desired operational length. Second, there is the problem of supporting the superconductor during its manufacture, and subsequently supporting the superconductor in its intended operational environment.

Several methods for the manufacture of superconductor devices have been suggested. For example, U.S. Patent No. 5,118,663, which issued to Woolf et al. for an invention entitled "Fabrication of Silver Coated High Temperature Ceramic Superconductor Fiber with Metal Substrate", and which is assigned to the same assignee as the present invention, discloses a method for electrophoretically coating a metal substrate with superconductor material. The Woolf et al. '663 patent, however, does not suggest how the superconducting capability of the end product might be further enhanced by subsequent treatment of the coated substrate. See also, U.S. Patent No. 5,073,240 which issued to Raggio et al. for an invention entitled "Anhydrous Electrophoretic Silver Coating Technique", and which is also assigned to the assignee of the present invention. In another example of a superconductor device, U.S. Patent No. 5,104,849, which issued to Shiga et al. for an invention entitled "Oxide Superconductor and Method of Manufacturing the Same", discloses a multi-layer superconductor which incorporates laminated layers of prepared material. The Shiga et al. '849 patent, however, does not teach or suggest any means, other than lamination, for joining the various layers together. Further, Shiga et al. do not indicate how the laminations might be manufactured for a continuous process where the desired end result is a long length superconductor wire.

All superconductor wires have the common attribute that the superconductor must somehow be properly supported. The supporting structure may be either a substrate or a superstrate but, due to the fragile nature of superconductor ceramic materials, there must be some support. Furthermore, there must be some way by which the superconductor is securely attached to the substrate or superstrate. For an example of the importance to be attributed to a substrate for a superconductor, consider U.S. Patent No. 4,994,633, which issued to Puhn for an invention entitled "Bend-tolerant Superconductor Cable", and which is assigned to the same assignee as the present invention. An additional concern is that the supported superconductor be functional in its intended operational environment.

It is well known in the literature that high temperature superconductor wires using the BiPb2223 composition are generally prepared using the "powder-in-tube" technique, wherein BiPb2223 powder is poured and then packed into silver tubes. The powder filled tubes are subsequently drawn down into thin wires. These thin wires are then subsequently subjected to a series of rollings and heat treatments. The length of these wires has been limited in part, by the size (diameter and length) of the silver tube that can be easily packed with powder and then drawn.

It is also well known that during the rolling step, the silver surface in contact with the superconductor material can become non-uniform or "sausaged." The non-flatness of the inner silver surface ultimately results in lower current density superconductor wires. Therefore, a method for producing long lengths of wire having high quality, flat, silver-superconductor interfaces is needed.

Extremely important considerations for a superconductor device are that the superconductor have a high critical current density (J_{c}), and that the superconductor be able to effectively operate at relatively high temperature, i.e. around the boiling point for liquid Nitrogen which is 77K. With both of these objectives in mind, the manufacture of a superconductor wire must meet certain specifications. More particularly, for the manufacture of a superconductor device it is necessary to achieve; 1) good alignment of the crystals in the superconductor material, 2) a high density for the superconductor material and, 3) crystal continuity in the ceramic superconductor along the length of the superconductor device.

It is known that crystalline grain growth and the resultant grain alignment in a superconductor material are enhanced by the presence of silver (Ag). More specifically, it is known that grain growth and alignment in a superconductor material is best achieved within the approximately thirty microns of superconductor material that is adjacent to the silver/superconductor interface. In addition to this phenomenon, it fortunately happens that silver is, in its own right, also a very good electrical conductor.

There have been suspicions, however, that silver does not have sufficient strength to serve as an effective substrate for a high temperature superconductor wire. As a consequence, other materials have also been considered. Specifically, nickel and its alloys have been demonstrated to be effective for this purpose. The trend away from silver, however, has been misplaced. Despite the earlier suspicions, silver has also been found to be an effective substrate. Indeed, as between silver and nickel and its alloys, for the reasons set forth above, silver is preferable. For purposes of the present invention, both silver and nickel and its alloys are considered suitable substrates for a high temperature superconductor wire.

First consider nickel. Nickel and its alloys are metals which has various attributes that make it desirable for use as a superconductor substrate during both the manufacturing process, and subsequently in the superconductor's operational environment. It has good tensile strength and, when subjected to the wide range of temperatures typically encountered in superconductor fabrication, it resists the tendency to creep which is typical of many metals. Another desirable characteristic of Nickel is that it is extremely oxidation resistant. A good example of the use of Nickel as a superconductor substrate is provided by U.S. Patent No. 5,006,507 which issued to Woolf et al. for an invention entitled "Nickel-based Substrate for Ceramic superconductor", and which is assigned to the same assignee as the present invention.

The use of nickel or any of its alloys as a substrate for a high temperature superconductor wire, however, does present some problems which are minimized or nonexistent when silver is used. Specifically, there will be some contamination of the superconductor material at the interface between the nickel and the superconductor. As indicated above, this does not happen with a silver substrate. In fact, the opposite is true. Grain growth and alignment in the superconductor material are actually enhanced in the near vicinity of the silver-superconductor interface.

The present invention recognizes that the use of silver to enhance the creation of a ceramic superconductor is best realized by properly positioning the silver and the superconductor as coated layers on the substrate during the manufacturing process. Further, the present invention recognizes that, this same process lends itself to the manufacture of relatively long superconductor wires.

In light of the above it is an object of the present invention to provide a method for manufacturing a multi-layer superconductor wire which has a high critical temperature which is in the range of temperatures from near the boiling point of nitrogen (77K) to above one hundred degrees Kelvin (100K). Another object of the present invention is to provide a method for manufacturing a multi-layer superconductor wire which exhibits highly aligned superconductor grains , as well as high superconductor density. Still another object of the present invention is to provide a method for manufacturing a multi-layer superconductor wire which has substantial length. An object of the present invention is to also provide a high critical temperature multi-layer superconductor wire which is manufactured by the method of the present invention. It is also an object of the present invention to provide a multi-layer superconductor wire which is relatively easy to manufacture, which is simple to use, and which is comparatively cost effective. Another object is to provide a superconductor/silver interface which is substantially flat and which provides for highly aligned superconductor grains.

### SUMMARY OF THE INVENTION

A method for manufacturing a multi-layer high critical temperature superconductor wire according to the invention is defined in the accompanying claims and includes the step of extending a metallic substrate wire or tape between a supply spool and a take-up spool. Preferably, the metallic substrate is silver, nickel, a nickel alloy or an iron alloy. As the wire substrate travels between the spools, successive layers of silver and superconductor material are alternately coated onto the substrate to create a multi-layer wire. For a silver substrate, successive layers of superconductor material and silver are alternately coated into the substrate. Preferably, for the present invention the superconductor material is either BiPb2223 or Bi2212. This multi-layer wire is then rolled and subsequently heat treated between one and three times to create the end product. In overview, the method of the present invention is seen as a two-phase process which comprises a layer coating phase, and a wire treatment phase.

The layer coating phase is accomplished between the supply spool and the take-up spool. First, when a nickel substrate is used, a layer of silver is electrophoretically deposited onto the nickel containing metallic wire substrate. This first silver layer is then densified by sintering the silver at about 910-930°C. For the preferred embodiment of a silver wire substrate, the above step is omitted. Next, for the preferred embodiment, a layer of superconductor material is electrophoretically deposited onto the silver wire substrate. Where a nickel substrate is used, the superconductor material is electrophoretically coated onto the silver coated substrate. This layer of superconductor material is sintered by heating at approximately 775-850°C. Subsequent layers of silver and superconductor material are electrophoretically deposited onto the wire and sintered to establish alternating layers of silver and superconductor material. The subsequent layers of silver are densified at as high a temperature (775-850°C) as possible without causing melting or leakage of the underlying superconductor material, and the subsequent layers of superconductor material are densified at approximately 775-850°C. For the resultant multi-layer wire, the final outer layer is silver. This multi-layer wire is collected on the take-up spool. As intended for the present invention, one, two or three layers of superconductor may be used.

In the wire treatment phase, the multi-layer wire is taken from the take-up spool and successively rolled to slowly change the morphology of the round wire to a flattened multi-layer wire configuration. This flattened wire is then heat treated at approximately 835°C for about 50-70 hours to effectuate crystalline grain growth in the superconductor material. Subsequently, the flattened multi-layer wire is rolled to improve the grain alignment and density in the superconductor material. The multi-layer wire is then again heat treated, as before, to improve the grain to grain contact, to densify the superconductor material, and to further effectuate crystalline grain growth in the superconductor material. One additional rolling and heating step may be needed to optimize the superconducting properties although more may be necessary. In accordance with the present invention, after the multi-layer wire has been flattened, subsequent rolling of the flattened multi-layer wire is done only about once between each of the subsequent heat treatments. Also, the final heat treatment may be accomplished for an extended period of time, such as for 80-300 hours.

The final end product is a high critical temperature superconductor wire which includes alternating layers of silver and superconductor material, and which has a substantially rectangular cross section. This multi-layer wire has a central silver or silver coated substrate surrounded by at least one layer of superconductor material and at least one silver protective outer layer. One of these silver layers is deposited directly on the substrate to act as a diffusion barrier if the substrate is a nickel or iron containing metal, and one of the silver layers serves as a protective outer layer for the multi-layer wire. For the present invention, each layer of superconductor material and each layer of silver is deposited onto the adjacent underlying layer, and the layers are alternated to position each layer of superconductor material between successive layers of silver.

The novel features of this invention, as well as the invention itself, both as to its structure and its operation will be best understood from the accompanying drawings, taken in conjunction with the accompanying description, in which similar reference characters refer to similar parts, and in which:
Figure 1 is a block diagram of the method for manufacturing the multi-layer wire of the present invention using a BiPb2223 superconductor material;
Figure 2 is a schematic diagram of the coating stations used in the method for manufacturing the multilayer wire of the present invention during the coating phase;
Figure 3 is a perspective view of the multi-layer wire of the present invention being rolled by a roller apparatus during the wire treatment phase;
Figure 4A - as seen prior to rolling;
Figure 4B is a cross sectional view of a multi-layer wire of the present invention as seen along the line 4-4 in Figure 3;
Figure 5A is a cross sectional view of the wire of the preferred embodiment after completion of the layer coating phase;
Figure 5B is a cross sectional view of the wire of the preferred embodiment after completion of the wire treatment phase; and
Figure 6 is a block diagram of the method for manufacturing the multi-layer wire of the present invention using a Bi2212 superconductor material.

### DESCRIPTION OF THE PREFERRED EMBODIMENTS

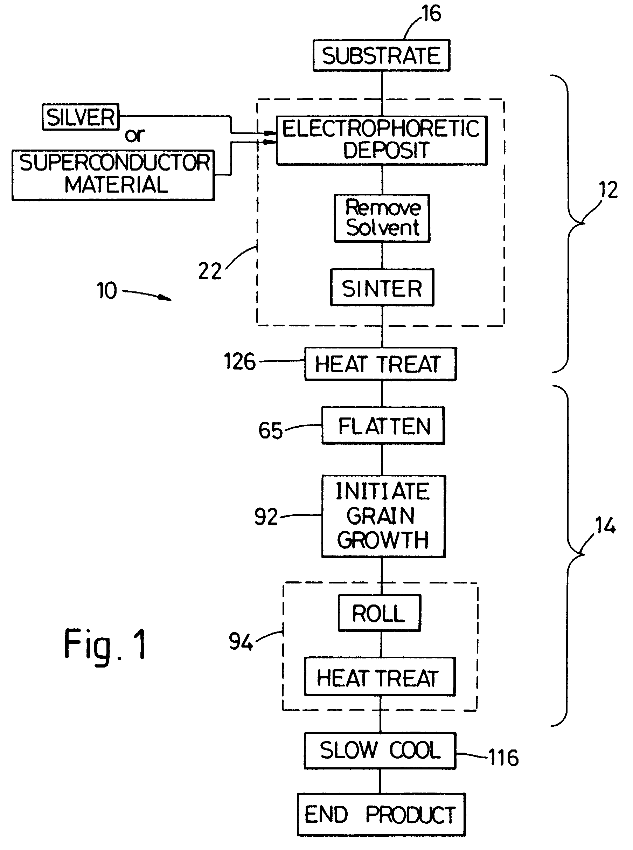

Referring initially to Figure 1, the method for manufacturing a multi-layer high critical temperature superconductor wire in accordance with the present invention is shown and generally designated 10. As shown, the method 10 generally includes a layer coating phase 12 and a wire treatment phase 14. Further, it is indicated in Figure 1 that the constituents of the multi-layer wire will include a substrate 16 with silver and a superconductor material.

For the present invention the substrate 16 is preferably made of a pure silver. The diameter of the silver wire should be between about 0.18 millimeters - 0.38 mm (7 and 15 mils), most preferably about 0.25 mm (10 mils), in order to have sufficient high temperature strength to be used in this process. Alternatively, substrate 16 may be made of nickel, a nickel alloy, or an iron alloy (e.g. Hoskins 875). Typical diameters of these wire substrates are fifty to seventy five (50-75) micrometers [microns]. If silver is not used for the substrate 16, examples of acceptable materials for the substrate 16 include the products which are commercially available and known as Haynes 214 or Duranickel 301. Importantly, the substrate 16 must have good tensile strength and resist creep when subjected to the tension forces and the wide range of temperatures necessary for fabrication of the superconductor wire. Further, the substrate 16 needs to be oxidation resistant and, if a non-silver substrate is used, it must be substantially nonreactive with silver. Additionally, it is necessary that the substrate 16 maintain these qualities over extended length of wire because, as intended for the present invention, lengths of wire in the range of from one to ten kilometers (1-10 km) are envisioned. Haynes 214 and Duranickel 301 satisfy these requirements.

As indicated above, a thick round or oval silver wire (approximately 250 micrometers (micron) diameter) or a silver tape (approximately 50 micrometers (microns) thick and 1-3 mm wide) is preferred for use as the substrate 16. When silver is used, however, the tension forces on the substrate 16 during manufacture must be kept below the tensile strength and the creep strength of silver. To this end, an effective method for keeping tension on the silver substrate within acceptable limits is disclosed in U.S Patent No. 5,080,296 to Raggio et al. which is assigned to the same assignee as the present invention. It should be emphasized that a silver wire will be a useable substrate only if exceptional means to reduce the tension are used, as described above, and only if the silver wire is of a sufficiently large diameter, such as 250 micrometers (microns).

Even where a nickel alloy substrate 16 is to be used, permissible tension forces are still an issue and the methods disclosed by Raggio et al. are still applicable. Although nickel alloy substrates 16 are much less sensitive to breaking than is silver during the layer coating phase 12 of manufacture, 250 micrometer (micron) diameter silver has sufficient strength. Indeed, with a nickel substrate, the silver diffusion barrier layer 82 next to the substrate 16 must be sufficiently thick and dense to prevent contamination of the superconductor during subsequent heat treatments in the wire treatment phase 14.

For the method 10 of the present invention, in the specific case where substrate 16 is made of a non-silver material, a silver powder is used for deposit on the substrate 16 and it is preferably a pure silver (Ag). A mixture of silver with another metal, such as palladium (Pd), could also be used. The cost for such a mixture, however, may be prohibitive. As indicated above, one purpose for using silver in the multi-layer wire of the present invention is to enhance crystalline grain growth and alignment in the superconductor (this is sometimes referred to as "texture"). In any case, for the present invention it is important that the silver density be greater than approximately 90% of the theoretical density at sintering temperatures of approximately eight hundred to eight hundred and fifty degrees Centigrade (800-850°C) for times of about 12 hours. Silver powder which achieves this density has a large surface area, e.g. in the range of from two to four square meters per gram (2-4 m²/g) and a Fisher sub-sieve size of approximately one-half micrometer (micron) (0.5 um). Such a silver powder is available commercially from Degussa/Metz Corporation and is known as Type K silver powder.

For the present invention, the superconductor material to be used is preferably BiPb2223. An exact formula for a superconductor material which has been successfully used in the method 10 is: Bi_{1.84}Pb_{0.34}Sr_{1.91}Ca_{2.03}Cu_{3.06}oxide. It is known that this particular BiPb2223 material, after suitable heat treatment, has a high critical temperature (approximately 105-110K) and it has good useable technical properties (i.e. good critical current density J_{c}) near the boiling temperature of nitrogen (77K). The powder for this material may be prepared by a spray drying process. Such material is commercially available from Seattle Specialty Ceramics. The powder is subsequently calcined in air at approximately eight hundred degrees Centigrade (800 °C) for approximately twelve hours (12 hrs) and cooled such that it has low carbon content of typically one hundred to three hundred parts per million by weight. At this point, the phase assemblage consists mainly of Bi2212 (Bi₂Sr₂CaCu₂oxide).

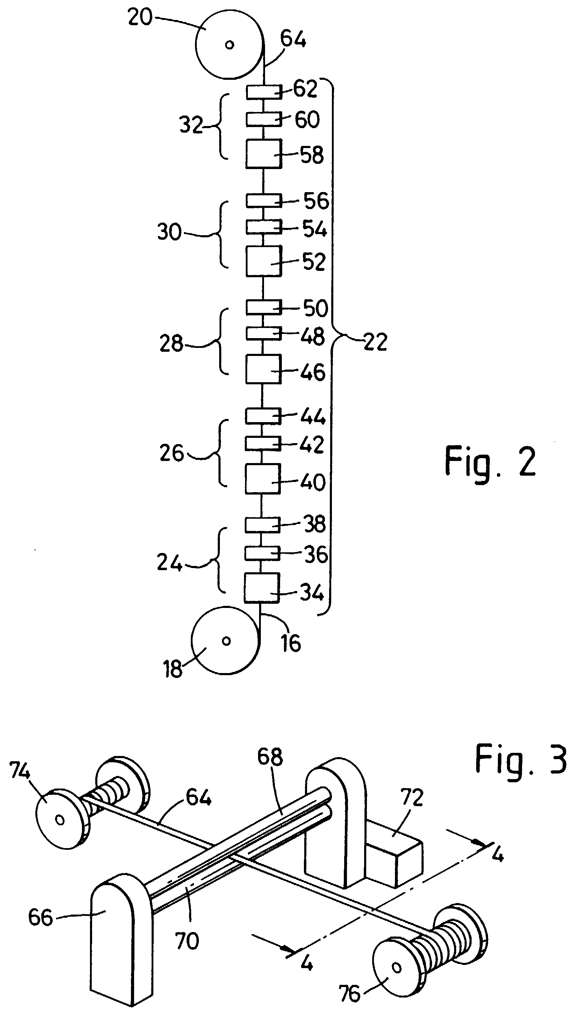

It is during the layer coating phase 12 that the silver and superconductor material are coated onto the substrate 16. This operation is schematically shown in Figure 2 where it can be seen that the substrate 16 is extended between a rotatable supply spool 18 and a rotatable take-up spool 20. The wire substrate 16 is placed in tension between the supply spool 18 and the take-up spool 20 as it is drawn through the processing zone 22. With reference to Figure 1, it will be seen that the layer coating phase 12 includes the steps of electrophoretically depositing silver and superconductor material onto the substrate 16, removing solvent from the deposited material and sintering the material. As indicated in Figure 2, this is accomplished by coating layers of material onto the substrate 16 in a predetermined sequence.

In Figure 2 it is seen that between supply spool 18 and take-up spool 20 there are, in sequence, a silver coating station 24 (if using a non-silver substrate, otherwise, coating station 24 can be eliminated), a superconductor coating station 26, a silver coating station 28, a superconductor coating station 30, and a silver coating station 32. It is to be appreciated that, although only five coating stations are shown in Figure 2, there can be as many such stations as desired. More specifically, when a silver substrate 16 is used there will be an equal number of silver coating stations and superconductor coating stations. For this case there can be anywhere between one and about three coating stations of each type. On the other hand, when a non-silver substrate 16 is used an additional silver coating station is required. Thus, for the case of a non-silver substrate 16 there can be between one and about three superconductor coating stations and between two and about four, respectively, silver coating stations.

Turning specifically to a consideration of the silver coating station 24, it is seen that station 24 includes, in sequence from supply spool 18 toward take-up spool 20, a slurry pool 34, a heater 36 and a heater 38. More specifically, the slurry pool 34 contains a slurry of silver powder and solvent from which the silver is electrophoretically coated onto the substrate 16 in a manner well known in the art (see U.S. Patent No. 5,118,663 to Woolf et al. discussed above).

After being drawn through the slurry pool 34, the substrate 16, with silver deposit, is passed through heater 36 where it is subjected to a temperature of approximately two hundred to five hundred degrees Centigrade (200-500°C) to remove any solvent remaining on the substrate 16. The next step is to pass the silver coated substrate through the heater 38 where the silver powder is sintered. This sintering is accomplished at a temperature of approximately 910-930°C.

It will be appreciated that the time for removal of solvent, and the time for sintering the deposited silver or superconductor, is dependent on the speed of travel of the substrate 16 and the dimensions of the heaters 36, 38, 42, 44, 48, 50, 54, 56, 60 and 62. Typically, the speed of travel for wire 16 is approximately O.5m/min. Each heater 36, 38, 42, 44, 48, 50, 54, 56, 60 and 62 is in the range of from 5.08 to 30.48 centimeters (2 to 12 inches) long. This effectively establishes a residence time in each heater of from about 5-50 seconds.

The amount of silver or superconductor which is deposited onto the substrate 16 will depend on the concentration of silver powder in the slurry, the speed of travel of the substrate 16 and the electrical potential used for the electrophoresis process. All of these variables are controllable, and can be set according to the desires of the operator. In order to reduce the fire hazard, and to help control unwanted combustion of solvent, the process environments in heaters 36, 38, 42, 44, 48, 50, 54, 56, 60 and 62 are accomplished in an atmosphere which is preferably approximately five percent oxygen and ninety five percent nitrogen (5% O₂ and 95% N₂), but which may be as high as one hundred percent oxygen (100% O₂).

It will be noted that the discussion here has involved coating station 24 and, that as stated above, for a silver substrate 16 coating station 24 can be eliminated.

Superconductor coating station 26 follows silver coating station 24 and it consists of a slurry pool 40 and the heaters 42 and 44. Here the slurry comprises granules of superconductor BiPb2223 and an appropriate solvent (such as propylene carbonate) with a charging agent (such as ethanolamine), all of which are well known in the art. Again, deposition of the material is accomplished using an electrophoresis process. This time, however, superconductor granules are deposited onto the silver or previously silver coated substrate 16. The heater 42 of superconductor coating station 26, similar to heater 36 of silver coating station 24, is used to remove solvent from the deposited superconductor granules. Also, heater 44 of station 26, similar to the heater 38 of station 24, is used to sinter the superconductor granules. The heater 44 of superconductor coating station 26, however, is adjusted to sinter the superconductor granules at a temperature of about seven hundred seventy five to eight hundred fifty degrees Centigrade (750-850 °C), which should be below the melting point of the coated superconductor material.

Silver coating station 28 follows superconductor coating station 26 in the processing zone 22. As shown, silver coating station 28 includes a slurry pool 46 a solvent removal heater 48 and a sintering heater 50. The temperature of heater 50 is approximately in the range of from seven hundred seventy five to eight hundred fifty degrees Centigrade (775-850 °C) which again should be below the melting point of the coated superconductor material.

The superconductor coating station 30 includes a slurry pool 52, a solvent removing heater 54 and a sintering heater 56. In all important respects, the superconductor coating station 30 is similar to the superconductor coating station 26.

The final station in the processing zone 22 is shown to be a silver coating station 32. There may, of course, be more silver coating stations and superconductor coating stations in the processing zone 22 than shown in Figure 2 but, in each case, for the preferred embodiment of the present invention the final station is a silver coating station. Similar to other stations in processing zone 22, silver coating station 32 has a slurry pool 58, a solvent removing heater 60 and a sintering heater 62 as described previously. Further, because the outer layer of silver will also serve as a protective coating the thickness of this outer silver layer may be two to three times thicker than the underlying layers of silver.

The result is a multi-layer superconductor wire 64 which is collected onto take-up spool 20. To help prevent diffusion bonding of the outer silver layers before this or any other batch heat treatment, a magnesium oxide (MgO) powder can be applied to the multi-layer wire 64 before it is collected on take-up spool 20. The wire on spool 20 is then heat treated in a batch mode to sinter the silver to approximately 95% of theoretical density so that it can be rolled during the wire treatment phase. Typically, this is done at about eight hundred degrees Centigrade (800 °C) for about twelve hours in air. This heat treatment process is indicated by block 126 in Figure 1. After heat treatment, the MgO powder, if it has been applied, can be removed by wiping it off.

Multi-layer wire 64 is next processed in the wire treatment phase 14. To begin the wire treatment phase, the multi-layer wire 64 is first flattened, as indicated by block 65 in Figure 1. In Figure 3, it is seen that the flattening of multi-layer wire 64 is accomplished using a roller device 66 of a type well known in the pertinent art. For the device 66, there is an upper roller 68 which is distanced from a counter-rotating lower roller 70. The distance between rollers 68 and 70 must be adjustable and it needs to be established with accuracy to within ten micrometers [microns (0.010mm)]. The drive unit 72 is provided to counter-rotate the rollers 68 and 70. As shown in Figure 3, the multi-layer wire 64 is presented to the roller device 66 from a supply spool 74 and it is taken from the roller device 66 by a take-up spool 76. At least initially, the supply spool 74 for the wire treatment phase 14 may, obviously, be the take-up spool 20 from the layer coating phase 12. Of course, if these spools are used during the batch heat treatments, they must be made out of a suitable high temperature material such as Haynes 214 or Inconel 601.

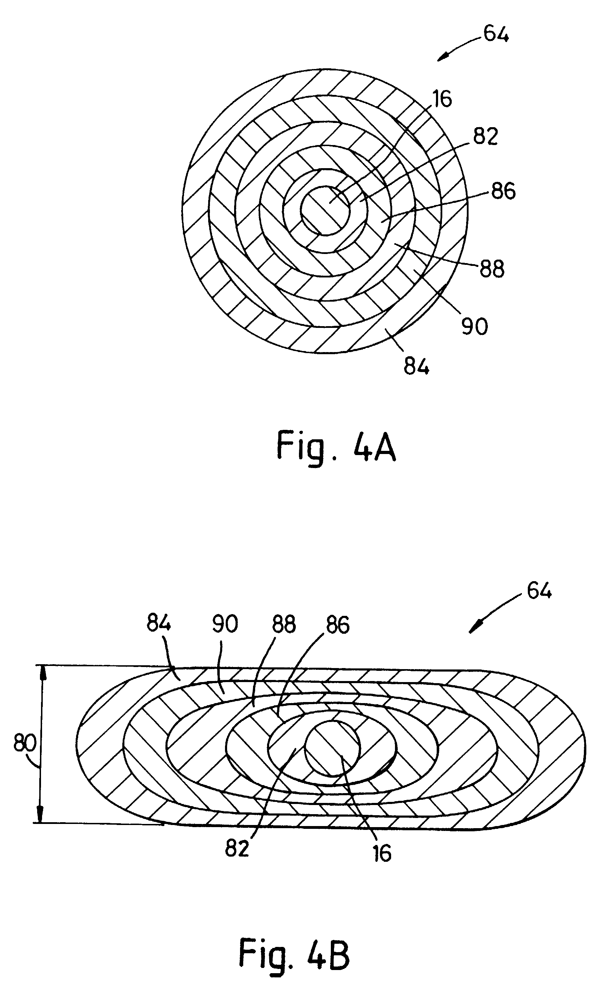

During the procedural step of flattening multi-layer wire 64, as indicated by block 65, there may be as many as twenty passes of the multi-layer wire 64 through the device 66. More specifically, it is preferred that there be less than a five percent (5%) reduction in the diameter/thickness of wire/tape 64 for each pass through the roller device 66. Further, it has been found to be helpful, though not necessary, if the wire 64 is annealed after each twenty percent (20%) reduction. The annealing at this point can be effectively accomplished by heating the multi-layer wire 64 in air to approximately five hundred degrees Centigrade (500°C) for about fifteen minutes. During the flattening step (block 65), the multi-layer wire 64 can be flattened from a circular cross section having a diameter of -approximately one millimeter (1.0 mm) to a substantially rectangular cross section having a thickness as shown in Figure 4B of approximately one hundred and fifty to two hundred and fifty micrometers [microns (150-250 um)].

In an alternate embodiment, the original substrate for the multi-layer wire can be of rectangular or near rectangular cross section i.e. a tape. If so, then the flattening step (block 65) can be eliminated or significantly modified in that fewer passes will be necessary. In any event, it is preferable that the multilayer wire 64 have a substantially rectangular cross section before the wire 64 is subsequently processed by being heat treated. A significant consideration for preference is that, with a rectangular configuration, the ceramic superconductor material can be confined closer to the neutral axis of the wire 64 during subsequent bending of the wire 64. Consequently, the ceramic superconductor will be less affected by tensile forces which can easily crack the ceramic superconductor. An in-depth consideration of the mechanical problems, and their solutions, associated with bending ceramic superconductor wire is set forth in the Puhn patent disclosed above. As an additional consideration, the grain alignment that occurs during the heat treatment phase is greatly improved if the superconductor is confined by nearby flat layers of silver.

In accordance with the present invention, an embodiment for the multi-layer wire 64 is shown in Figure 4B. Figure 4A shows this particular embodiment prior to being flattened by the rolling process. In Figure 4B it can be seen that the flattened wire 64 has a thickness which is indicated by the distance 80. It is important to note that intermediate steps cause a gradual reduction in the thickness of the wire 64 during step 65. Specifically, at step 65 the thickness (distance 80) is reduced to a range between approximately one hundred and fifty and two hundred and fifty microns (150-250 um). Preferably, after the cycles 94 the distance 80 is approximately equal to one hundred and two hundred microns (100-200 um) and the aspect ratio of the wire 64 is approximately between ten to one and twenty to one. Stated differently, the multi-layer wire 64 is approximately ten to twenty times wider than it is thick. Figure 4B also shows that the first layer of silver which is coated onto the substrate 16 is positioned to act as a diffusion barrier 82 which is intended to effectively separate the nickel containing substrate 16 from the layers of superconductor material which are subsequently coated onto the substrate 16. Figure4B also shows that the outermost layer of silver is positioned to act as a protective coating or layer 84. As indicated above, the protective layer 84 can be two or three times as thick as the other layers of silver in the multi-layer wire 64.

It will be seen that between diffusion barrier 82 and protective layer 84 for the particular configuration of multi-layer wire 64 shown in Figure 4B, there are various alternating intermediate layers of silver and superconductor material. Specifically, these layers include a superconductor material layer 86 which is deposited next to the diffusion barrier 82. Next is a silver layer 88 and, then, between silver layer 88 and the protective layer 84 is another superconductor material layer 90. Importantly, for the present invention the superconductor material layers should not be thicker than approximately sixty micrometers [microns (60 um)]. This is so because, as indicated above, superconductor material which is within approximately thirty micrometers [microns (30 um)] of a silver/superconductor interface will have enhanced crystalline grain growth and alignment.

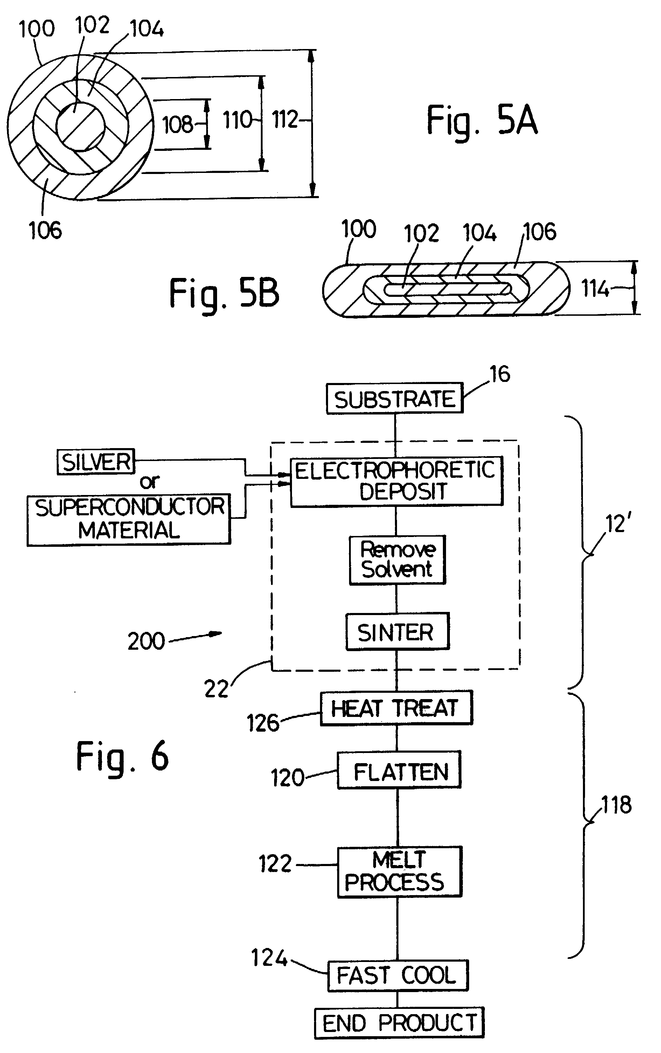

Figures 5A and 5B show the preferred embodiment for a superconductor wire 100 as manufactured by the methods of the present invention. Specifically, Figure 5A shows the wire 100 after it has progressed through the layer coating phase 12 but before it has been flattened. Figure 5B on the other hand shows the wire 100 after being flattened. In Figure 5A it will be seen that wire 100 includes a silver substrate 102 which is successively surrounded by a superconductor layer 104 and a silver protective layer 106. As indicated, the initial diameter 108 of the silver wire substrate 102 is approximately 250 micrometers (microns). The outer diameter 110 of the superconductor layer 104 is in the range of approximately 450-750 micrometers (microns) and the outer diameter of wire 100 including the silver protective layer 106 is on the order of approximately one millimeter (1mm). In general, superconductor layers will be about 100-250 micrometers (microns) thick and silver layers will be about 50-150 micrometers (microns) thick, except for the outer silver layer, which will be about 100-300 micrometers (microns) thick. All of this, of course, changes after the wire 100 has been flattened.

As shown in Figure 5B, after being flattened, the thickness 114 of wire 100 is in the range of approximately 100-200 micrometers (microns). This is approximately the same as the thickness for the wire 64 after it has been subjected to the flattening step.

After the multi-layer wire 64 has been flattened it is necessary to sinter the superconductor. This process is initiated as indicated by block 92 in Figure 1 and is accomplished by subjecting the wire 64 to a temperature of approximately eight hundred and thirty five degrees Centigrade for about sixty hours in air. This heat treatment initiates the grain growth of the superconductor in multi-layer wire 64. As indicated in Figure 1, the wire 64 is then subjected to repetitive cycles 94 of rolling and heat treatment. During the subsequent rolling/heating cycle 94 preferably only one pass of the multi-layer wire 64 is made through the roller device 66 between each subsequent heat treatment of the multi-layer wire 64. The importance of this single pass is that it helps densify the superconductor and also helps to align the crystals so that their long axes are parallel to the surface of the tape. During the rolling/heating cycle 94, heat treatments are conducted at approximately eight hundred and thirty five degrees Centigrade (835°C) and, except for the very last heat treatment, last approximately forty to seventy hours. The last heat treatment, with no subsequent rolling, may be conducted for between seventy and three hundred hours (70-300 hrs). Typically, between one and three cycles are accomplished during the cycles 94.

In the wire treatment phase 14, the separate heat treatments in cycles 94 are preferably accomplished in air. It will be appreciated by the skilled artisan, however, that other oxidizing atmospheres are also suitable for this purpose, such as partial pressure of oxygen of 5-10 %.

At this point, a distinction is to be made between the steps involved in the manufacturing processes for the two most likely used superconductor materials, which are BiPb2223 and Bi2212. For the process of manufacturing a superconductor wire 64 having a BiPb2223 superconductor material, the process steps are as shown in Figure 1. On the other hand, the process of manufacturing a superconductor wire 64 having a Bi2212 superconductor material follows the steps generally set forth in Figure 6. As seen in a comparison of Figure 1 and Figure 6, the distinction lies in the respective wire treatment phases.

Wire treatment phase 14 for wire 64 having a BiPb2223 superconductor material is as disclosed above, with one additional step. This is the slow cool step 116 shown in Figure 1 According to the present invention, this slow cool step 116 is accomplished after the final heat treatment of cycle 94. More specifically, slow cool step 116 is accomplished by slowly cooling the wire 64/100 at a rate in the range of 25-50°C each hour from a sintering temperature of approximately 835°C down to a temperature of approximately 400°C or lower. As is well known in the art, this is done to optimize the oxygen content of the BiPb2223 superconductor, and thereby attain high critical temperatures (T_{c}) in the range of approximately 105-110 K.

Turning now to Figure 6, it will be seen that the method 200 for manufacturing a superconductor wire having a Bi2212 superconductor material includes a layer coating phase 12'that, in all essential respects, is similar to the layer coating phase 12 of method 10. As with the method 10, method 200 requires a heat treatment of the wire before the rolling operation. In Figure 6. this step is shown as block 126 and is, in all important respects, similar to the heat treatment step of block 126 described above for method 10. Method 200, however, includes a wire treatment phase 118 that is somewhat different from the wire treatment phase 14 of method 10. Specifically, although wire treatment phase 118 includes the step of flattening the wire, see block 120, which is similar to the flattening step disclosed above for method 10, wire treatment phase 118 also includes a melt process indicated by block 122 which is different. This melt process is accomplished by first heating the flattened wire in air at a temperature of approximately eight hundred and eighty six degrees Centigrade for approximately six minutes (886°C/6mins). The wire is then gradually cooled down at the rate of about five degrees Centigrade per hour (5°C/hr) until a temperature of about eight hundred and thirty six degrees Centigrade (836°C) is attained.

As further indicated in Figure 6, there is a fast cool step 124 which is accomplished after the wire has been gradually cooled to about 836°C. In fast cool step 124, the wire is rapidly cooled from the temperature of about 835 °C down to a temperature of about 400 °C at a rate in the range of approximately 800-1200 °C per hour. As is well known in the art, this fast cooling step optimizes the oxygen content of the Bi2212 superconductor to yield high critical temperatures (T_{c}) in the range of approximately 90-95 K.

It is to be noted that the superconductor material of the end product, regardless whether it be BiPb2223 or Bi2212, may contain silver of approximately 0-50 volume percent. This silver may be either silver powder or silver flake.

While the particular method for manufacturing a multilayer high critical temperature superconductor wire as herein shown and disclosed in detail is fully capable of obtaining the objects and providing the advantages herein before stated, it is to be understood that it is merely illustrative of the presently preferred embodiments of the invention and that no limitations are intended to the details of the construction or design herein shown other than as defined in the appended claims. For example, the electrophoretic coating process may be replaced by a spray coating, dip coating, electrodeposition, or other process well known in the art for producing thin layers of material on substrates. In addition, other high temperature superconductor materials are contemplated such as the Tl-based materials.

## Claims

1. A method of manufacturing a multi-layer high critical temperature superconductor wire, having a critical temperature above about 77K, which comprises the steps of:
extending a metallic wire substrate between a rotatable supply spool and a rotatable take-up spool;
drawing said wire substrate from said supply spool to said take-up spool through a processing zone with a predetermined tension on said wire substrate, wherein, if said wire is not silver, said processing zone has a first silver coating station, said silver coating station being used for coating said wire with a layer of silver, and wherein if said wire is silver, said first silver coating station is omitted, and said processing zone has a superconductor material coating station for coating said wire with a layer of superconductor material;
following said superconductor coating station in said processing zone with a further silver coating station to surround said layer of superconductor material with silver; and
rotating said take-up spool to wind said wire around said take-up spool to form a coil of said multi-layer wire;
characterised in that said multi-layer wire has after said rotating step a starting morphology and said method further comprises after said rotating step the successive steps of:
a first rolling of said multi-layer wire to change said starting morphology of said wire into a flattened wire; and
a first heating of said flattened wire to effectuate crystalline grain growth in said superconductor material;
the method further comprising the steps of:
a subsequent rolling of said flattened wire to improve grain alignment and density in said superconductor material; and
a subsequent heating of said flattened wire thereby improving grain to grain contact in said superconductor material, enhancing current density capability for said superconductor material, and further effectuating crystalline grain growth in said superconductor material.

2. A method according to claim 1 wherein said layer of silver is sintered at about 800°C for about 12 hours to sinter said silver layer.

3. A method according to any one of the preceding claims wherein said superconductor material is Bi Pb2223, or Bi2212.

4. A method according to any one of the preceding claims wherein said coating of said wire by said first silver coating station comprises the steps of:
electrophoretically depositing silver powder on said wire substrate from a slurry including a solvent and said silver powder;
an initial heating of said deposited silver powder to remove said solvent therefrom; and
a next heating of said deposited silver powder to sinter said silver powder and establish a first layer of silver on said substrate for said multi-layer wire.

5. A method according to claim 4 wherein said initial heating of said deposited silver powder by said first silver coating station is accomplished at approximately two to five hundred degrees Centigrade (200-500°C) and said next heating of said deposited silver powder by said first silver coating station is accomplished at approximately nine hundred and twenty degrees Centigrade (920°C).

6. A method according to any one of the preceding claims wherein said coating of said wire by said superconductor material coating station in said processing zone comprises the steps of:
electrophoretically depositing superconductor granules on silver of said wire from a slurry including a solvent and said superconductor granules;
an initial heating of said deposited superconductor granules to remove said solvent therefrom; and
a next heating of said deposited superconductor granules to sinter said superconductor granules and establish a layer of superconductor material on said multi-layer wire.

7. A method according to claim 6 wherein said initial heating of said superconductor granules is accomplished at approximately two to five hundred degrees Centigrade (200-500°C) and said next heating of said superconductor granules is accomplished at approximately seven hundred seventy five to eight hundred fifty degrees Centigrade (775-859°C).

8. A method according to any one of the preceding claims wherein said processing zone has a further one or more superconductor material coating stations, each of which is followed by a further silver coating station.

9. A method according to claim 8 wherein said coating of said wire by said further silver coating station comprises the steps of:
electrophoretically depositing silver powder on an exposed said layer of superconductor material from a slurry including a solvent and said silver powder;
an initial heating of said deposited silver powder to remove said solvent therefrom; and
a next heating of said deposited silver powder to densify said silver powder and establish a outer layer of silver on said substrate for said multi-layer wire.

10. A method according to claim 9 wherein said initial heating of said deposited silver powder by said later silver coating station is accomplished at approximately two to five hundred degrees Centigrade (200-500°C) and said next heating of said deposited silver powder by said later silver coating station is accomplished at approximately seven hundred seventy five to eight hundred fifty degrees Centigrade (775-859°C).

11. A method according to claim 1 wherein said step of first heating said flattened wire and said subsequent heating step of said flattened wire is accomplished at approximately eight hundred and thirty five degrees Centigrade for about seventy hours (835°C/70 hrs) in air.

12. A method according to claim 11 wherein said method comprises a plurality of subsequent heating steps and one of said heating steps is a final heating step, and said final heating step being accomplished at approximately eight hundred and thirty five degrees Centigrade for between about seventy and three hundred hours.

13. A method according to claim 4 wherein said substrate comprises by approximate percentage of weight Ni (76.5%), Fe (3%), Cr (16%), and Al (4.5%) and is approximately 50 micrometers (microns) in diameter.

14. A method according to any one of the preceding claims wherein said silver coating is made from a silver powder which comprises grains having a surface area greater than approximately two square meters per gram (>2 m²/g).

15. A method according to any one of claims 9 to 14 wherein said step of first heating said flattened wire is accomplished in air at about eight hundred and eighty six degrees Centigrade for about six minutes (886°C/mins) with a subsequent cool down to about eight hundred and thirty six degrees Centigrade (836°C), said cool down being accomplished by a reduction of about five degrees Centigrade per hour (5°C/hr).

## Patentansprüche

1. Verfahren zur Herstellung eines mehrschichtigen, eine hohe kritische Temperatur aufweisenden supraleitenden Drahts mit einer kritischen Temperatur oberhalb etwa 77 K durch die folgenden Stufen:
Recken eines Metalldrahtsubstrats zwischen einer drehbaren Zufuhrrolle und einer drehbaren Abnahmerolle;
Ziehen des Drahtsubstrats von der Zufuhrrolle zu der Abnahmerolle durch eine Verarbeitungszone bei einer vorgegebenen Spannung auf dem Drahtsubstrat, wobei die Verarbeitungszone - wenn der Draht nicht aus Silber besteht - eine erste Silberbeschichtungsstation, die zur Beschichtung des Drahts mit einer Silberschicht verwendet wird, aufweist und wobei - wenn der Draht aus Silber besteht - auf die erste Silberbeschichtungsstation verzichtet wird, und die Verarbeitungszone eine Supraleitermaterialbeschichtungsstation zum Beschichten des Drahts mit einer Schicht aus supraleitendem Material aufweist;
Bereitstellen einer weiteren Silberbeschichtungsstation anschließend an die Supraleiterbeschichtungsstation in der Verarbeitungszone zum Umgeben der Schicht des supraleitenden Materials mit Silber und
Drehen der Abnahmerolle zum Aufwickeln des Drahts auf der Abnahmerolle zur Bildung einer Spule des mehrschichtigen Drahts;
dadurch gekennzeichnet, daß der mehrschichtige Draht nach der Dreh- bzw. Rotationsstufe eine Ausgangsmorphologie aufweist und das Verfahren des weiteren nach der Dreh- bzw. Rotationsstufe die folgenden aufeinanderfolgenden Stufen umfaßt:
ein erstes Walzen des mehrschichtigen Drahts zur Veränderung der Ausgangsmorphologie des Drahts hin zu einem abgeflachten Draht und
ein erstes Erwärmen des abgeflachten Drahts zur Herbeiführung eines Kristallkornwachstums in dem supraleitenden Material;
wobei das Verfahren des weiteren die folgenden Stufen umfaßt:
ein anschließendes Walzen des abgeflachten Drahts zur Verbesserung der Kornorientierung und der Dichte in dem supraleitenden Material und
ein nachfolgendes Erwärmen des abgeflachten Drahts zur Verbesserung des Korn-zu-Korn-Kontakts in dem supraleitenden Material, zum Erhöhen der Stromdichteleistungsfähigkeit des supraleitenden Materials und zum weiteren Bewirken eines Kristallkornwachstums in dem supraleitenden Material.

2. Verfahren nach Anspruch 1, wobei die Silberschicht etwa 12 h bei etwa 800°C gesintert wird, um die Silberschicht zu sintern.

3. Verfahren nach einem der vorhergehenden Ansprüche, wobei das supraleitende Material BiPb2223 oder Bi2212 ist.

4. Verfahren nach einem der vorhergehenden Ansprüche, wobei das Beschichten des Drahts mittels der ersten Silberbeschichtungsstation die folgenden Stufen umfaßt:
Elektroabscheiden von Silberpulver auf dem Drahtsubstrat aus einer ein Lösungsmittel und das Silberpulver enthaltenden Aufschlämmung;
anfängliches Erwärmen des abgeschiedenen Silberpulvers zur Entfernung des Lösungsmittels daraus und
anschließendes Erwärmen des abgeschiedenen Silberpulvers zum Sintern des Silberpulvers und zur Schaffung einer ersten Schicht aus Silber auf dem Substrat für den mehrschichtigen Draht.

5. Verfahren nach Anspruch 4, wobei das anfängliche Erwärmen des abgeschiedenen Silberpulvers mittels der ersten Silberbeschichtungsstation bei etwa 200 - 500°C erfolgt und das anschließende Erwärmen des abgeschiedenen Silberpulvers mittels der ersten Silberbeschichtungsstation bei etwa 920°C erfolgt.

6. Verfahren nach einem der vorhergehenden Ansprüche, wobei das Beschichten des Drahts mittels der Supraleitermaterialbeschichtungsstation in der Verarbeitungszone die folgenden Stufen umfaßt:
Elektroabscheiden von supraleitendem Granulat auf silber des Drahts aus einer ein Lösungsmittel und das supraleitende Granulat enthaltenden Aufschlämmung;
anfängliches Erwärmen des abgeschiedenen supraleitenden Granulats zur Entfernung des Lösungsmittels daraus und
anschließendes Erwärmen des abgeschiedenen supraleitenden Granulats zum sintern des supraleitenden Granulats und zur Schaffung einer Schicht des supraleitenden Materials auf dem mehrschichtigen Draht.

7. Verfahren nach Anspruch 6, wobei das anfängliche Erwärmen des supraleitenden Granulats bei etwa 200 - 500°C erfolgt und das anschließende Erwärmen des supraleitenden Granulats bei etwa 775 - 859°C erfolgt.

8. Verfahren nach einem der vorhergehenden Ansprüche, wobei die Verarbeitungszone eine oder mehrere weitere Supraleitermaterialbeschichtungsstationen aufweist, der (denen) jeweils eine weitere Silberbeschichtungsstation folgt.

9. Verfahren nach Anspruch 8, wobei das Beschichten des Drahts mittels der weiteren Silberbeschichtungsstation die folgenden stufen umfaßt:
Elektroabscheiden von Silberpulver auf einer freiliegenden, genannten Schicht des supraleitenden Materials aus einer ein Lösungsmittel und das silberpulver enthaltenden Aufschlämmung;
anfängliches Erwärmen des abgeschiedenen Silberpulvers zur Entfernung des Lösungsmittels daraus; und
anschließendes Erwärmen des abgeschiedenen Silberpulvers zur Verdichtung des Silberpulvers und zur Schaffung einer äußeren Silberschicht auf dem Substrat für den mehrschichtigen Draht.

10. Verfahren nach Anspruch 9, wobei das anfängliche Erwärmen des abgeschiedenen Silberpulvers mittels der späteren Silberbeschichtungsstation bei etwa 200 - 500°C erfolgt und das anschließende Erwärmen des abgeschiedenen Silberpulvers mittels der späteren Silberbeschichtungsstation bei etwa 775 - 859°C erfolgt.

11. Verfahren nach Anspruch 1, wobei die Stufe des anfänglichen Erwärmens des abgeflachten Drahts und die nachfolgende Erwärmungsstufe des abgeflachten Drahts bei etwa 835°C während etwa 70 h an Luft erfolgen.

12. Verfahren nach Anspruch 11, wobei das Verfahren mehrere aufeinanderfolgende Erwärmungsstufen umfaßt, wobei eine der Erwärmungsstufen die abschließende Erwärmungsstufe ist und wobei die abschließende Erwärmungsstufe bei etwa 835°C während einer Zeit von etwa 70 - 300 h erfolgt.

13. Verfahren nach Anspruch 4, wobei das Substrat aus etwa 76,5% Gew.-% Ni, 3 Gew.-% Fe, 16 Gew.-% Cr und 4,5 Gew.-% Al enthalt und einen Durchmesser von etwa 50 µm aufweist.

14. Verfahren nach einem der vorhergehenden Ansprüche, wobei der Silberüberzug aus einem Silberpulver besteht, das Körnchen mit einer Oberfläche von mehr als etwa 2 m²/g umfaßt.

15. Verfahren nach einem der Ansprüche 9 bis 14, wobei die Stufe des anfänglichen Erwärmens des abgeflachten Drahts an Luft etwa 6 min bei etwa 886°C, gefolgt von einem anschließenden Abkühlen auf etwa 836°C erfolgt, wobei das Abküblen durch eine Verringerung der Temperatur von etwa 5°C/h erfolgt.

## Revendications

1. Procédé de fabrication d'un fil supraconducteur multicouches à température critique élevée, présentant une température critique supérieure à environ 77 K, qui comprend les étapes consistant à :
- étendre un substrat de fil métallique entre une bobine débitrice rotative et une bobine réceptrice rotative ;
- étirer ledit substrat de fil entre ladite bobine débitrice et ladite bobine réceptrice à travers une zone de traitement en appliquant une tension prédéterminée sur ledit substrat de fil, dans lequel, si ledit fil n'est pas en argent, ladite zone de traitement présente un premier poste de revêtement d'argent, ledit poste de revêtement d'argent étant utilisé pour revêtir ledit fil d'une couche d'argent et dans lequel, si ledit fil est en argent, ledit premier poste de revêtement d'argent est omis, et ladite zone de traitement présente un poste de revêtement de matériau supraconducteur pour revêtir ledit fil d'une couche de matériau supraconducteur ;
- faire suivre ledit poste de revêtement de matériau supraconducteur dans ladite zone de traitement d'un autre poste de revêtement d'argent pour entourer d'argent ladite couche de matériau supraconducteur ; et
- faire tourner ladite bobine réceptrice afin d'enrouler ledit fil autour de ladite bobine réceptrice pour former une bobine dudit fil multicouches ;
caractérisé en ce que ledit fil multicouches présente à la suite de l'étape de rotation une morphologie initiale et ledit procédé comprend en outre les étapes successives consistant à :
- laminer tout d'abord ledit fil multicouches afin de transformer ladite morphologie initiale dudit fil en un fil aplati ; et
- chauffer tout d'abord ledit fil aplati afin de permettre la croissance de grains cristallins dans ledit matériau supraconducteur ;
le procédé comprenant en outre les étapes consistant à :
- laminer ensuite ledit fil aplati afin d'améliorer l'alignement et la densité des grains dans ledit matériau supraconducteur ; et
- chauffer ensuite ledit fil aplati, améliorant ainsi le contact entre les grains dans ledit matériau supraconducteur, renforçant ainsi l'aptitude dudit matériau supraconducteur à accroître sa densité actuelle et permettre en outre une croissance des grains cristallins dans ledit matériau supraconducteur.

2. Procédé selon la revendication 1, dans lequel ladite couche d'argent est frittée et agglomérée à une température d'environ 800°C pendant environ 12 heures.

3. Procédé selon l'une quelconque des revendications précédentes, dans lequel ledit matériau supraconducteur est Bi Pb2223 ou Bi2212.

4. Procédé selon l'une quelconque des revendications précédentes, dans lequel ledit revêtement dudit fil par ledit premier poste de revêtement d'argent comprend les étapes consistant à réaliser :
- un dépôt électrophorétique de poudre d'argent sur ledit substrat de fil à partir d'une suspension comprenant un solvant et ladite poudre d'argent ;
- un chauffage initial de ladite poudre d'argent déposée afin d'en éliminer ledit solvant ; et
- un chauffage suivant de ladite poudre d'argent déposée afin de fritter ladite poudre d'argent et établir une première couche d'argent sur ledit substrat pour ledit fil multicouches.

5. Procédé selon la revendication 4, dans lequel ledit chauffage initial de ladite poudre d'argent déposée par ledit premier poste de revêtement d'argent est réalisé à une température comprise entre environ deux et cinq cents degrés centigrades (200-500°C) et ledit chauffage suivant de ladite poudre d'argent déposée par ledit premier poste de revêtement d'argent est réalisé à une température approximative de neuf vingt degrés centigrades (920°C).

6. Procédé selon l'une quelconque des revendications précédentes, dans lequel ledit revêtement dudit fil par ledit poste de revêtement de matériau supraconducteur dans ladite zone de traitement comprend les étapes consistant en :
- la réalisation d'un dépôt électrophorétique de granules supraconductrices sur l'argent dudit fil à partir d'une suspension comprenant un solvant et lesdites granules supraconductrices ;
- un chauffage initial desdites granules supraconductrices déposées afin d'en éliminer ledit solvant ; et
- un chauffage suivant desdites granules supraconductrices afin de fritter lesdites granules supraconductrices et établir une couche de matériau supraconducteur sur ledit fil multicouches.

7. Procédé selon la revendication 6, dans lequel ledit chauffage initial desdites granules supraconductrices est réalisé à une température comprise entre environ deux et cinq cents degrés centigrades (200-500°C) et ledit chauffage suivant desdites granules supraconductrices déposées est réalisé à une température approximative comprise entre sept cent soixante quinze et huit cent cinquante neuf degrés centigrades (775-859°C).

8. Procédé selon l'une quelconque des revendications précédentes, dans lequel ladite zone de traitement présente un ou plusieurs autres postes de revêtement de matériau supraconducteur, chacun d'entre eux étant suivi d'un autre poste de revêtement d'argent.

9. Procédé selon la revendication 8, dans lequel ledit revêtement dudit fil par ledit autre poste de revêtement d'argent comprend les étapes consistant en :
- la réalisation d'un dépôt électrophorétique de ladite poudre d'argent sur une dite couche exposée de matériau supraconducteur à partir d'une suspension comprenant un solvant et ladite poudre d'argent ;
- un chauffage initial de ladite poudre d'argent déposée afin d'en éliminer le solvant ; et
- un chauffage suivant de ladite poudre d'argent déposée afin de densifier ladite poudre d'argent et d'établir une couche extérieure d'argent sur ledit substrat pour ledit fil multicouches.

10. Procédé selon la revendication 9, dans lequel ledit chauffage initial est réalisé à une température comprise entre environ deux et cinq cents degrés centigrades (200-500°C) et ledit chauffage suivant de ladite poudre d'argent déposée par ledit poste de revêtement d'argent ultérieur est réalisé à une température approximative comprise entre sept cent soixante quinze et huit cent cinquante neuf degrés centigrades (775-859°C).

11. Procédé selon la revendication 1, dans lequel ladite étape consistant à chauffer tout d'abord ledit fil aplati et ladite étape consistant à chauffer ensuite ledit fil aplati sont réalisées dans l'air à une température approximative de huit cent trente cinq degrés centigrades pendant soixante dix heures (835°C/70 heures).

12. Procédé selon la revendication 11, dans lequel ledit procédé comprend une pluralité d'étapes de chauffage successives et une desdites étapes de chauffage est une étape de chauffage finale, et ladite étape de chauffage finale étant réalisée à une température approximative de huit cent trente cinq degrés centigrades pendant une durée comprise entre environ soixante dix et trois cents heures.

13. Procédé selon la revendication 4, dans lequel ledit substrat comprend en pourcentage approximatif en poids les éléments Ni (76,5 %), Fe (3 %), Cr (16 %) et Al (4,5 %) et mesure environ 50 micromètres de diamètre.

14. Procédé selon l'une quelconque des revendications précédentes, dans lequel ledit revêtement d'argent est réalisé à partir d'une poudre d'argent qui comprend des grains présentant une surface spécifique supérieure à environ deux mètres carrés par gramme (> 2 m²/g).

15. Procédé selon l'une quelconque des revendications 9 à 14, dans lequel ladite étape consistant à chauffer tout d'abord ledit fil aplati est réalisée dans l'air à une température approximative de huit cent quatre vingt six degrés centigrades pendant environ six minutes (886°C/mn) et est suivie d'un refroidissement à environ huit cent trente six degrés centigrades (836°C), ledit refroidissement étant exécuté en diminuant la température d'environ cinq degrés centigrades toutes les heures (5°C/h).
